# EUROPEAN PATENT SPECIFICATION

(11) **EP 1 190 111 B1**
(45) Date of publication and mention of the grant of the patent: **24.08.2005**
(21) Application number: 00943355.8
(22) Date of filing: 29.06.2000
(51) Int. Cl.: C23C 16/453, C23C 16/513, C23C 16/46

(54) **METHOD OF COATING CERAMICS USING CCVD**
VERFAHREN ZUR BESCHICHTUNG VON KERAMIKEN MITTELS CCVD
PROCEDE CCVD DE REVETEMENT DE CERAMIQUES

(30) Priority: 02.07.1999 US 349213
(43) Date of publication of application: 27.03.2002
(73) Proprietor: nGimat Co., Georgia 30341-2107 (US)
(72) Inventor: HUNT, Andrew, Tye, Atlanta, GA 30342 (US); MCENTYRE, John, Eric, Atlanta, GA 30360 (US); NEUMAN, George, Andrew, Suwanee, GA 30024 (US); VINSON, Matthew, Scott, Atlanta, GA 30346 (US)
(74) Representative: Bankes, Stephen Charles Digby
(86) International application number: PCT/US2000/018163
(87) International publication number: WO 2001/002622

(56) References cited:
- EP-A- 0 491 521
- EP-A- 0 709 487
- EP-A- 0 976 847
- WO-A-99/29917

## Description

The present invention is directed to a method of coating brittle substrates. In particular, the invention is directed to the use of combustion chemical vapor deposition CCVD or sprayed solutions from pressurized heated liquids, to produce various types of coatings on ceramics such as glass and glass products for enhancing one or more characteristics of the ceramic.

### Background of the Invention

Various methods and apparatus for placing coatings on glass have herebefore been known. These coatings can affect one or more properties of the glass including but not limited to: abrasion resistance; hydrophobic or hydrophilic; tint or other aesthetic features; electrical conduction or resistance; optical properties; and durability. In addition, combined chemical vapor deposition CCVD has been used to produce high quality coatings on non-glass substrates. CCVD is described in detail in the patents cited below. The CCVD technique as defined within this application broadly encompasses flame assisted deposition (FAD) in which the deposition vapor that is entrained in hot gasses contacts the substrate thereby forming the film or coating. Another coating method using a concentrated heating technique is known as controlled atmosphere chemical vapor deposition CACVD. This coating method is also described in detail in the reference cited below. What is lacking in the prior methods and devices, however, is the ability to produce coatings on glass using CCVD, thereby making use of the numerous advantages of the CCVD process. The term "glass" in general is defined as any material that solidifies from the molten state to the solid state without crystallization thereof. The term "glass" in the present context is defined broadly as those materials that crack, break or fail prior to plastic deformation of the material. When these materials have a high coefficient of thermal expansion, localized heating results in thermal shock to the material, thereby breaking or cracking the glass. Previously known CCVD, FAD or other concentrated-heat deposition processes are not suitable for coating these materials, as the localized heating of the glass substrate by the deposition process may result in the above described damage to the glass.

U.S. Patent No. 3,888,649, issued on June 10, 1975 to Simhan discloses a nozzle for chemical vapor deposition of coatings. The converging nozzle is used to coat glass substrates with metal oxides. Flame masking of glass articles for metal oxide film deposition is taught in U.S. Patent No. 3,934,063, issued on January 20, 1976 to Dubble. The disclosed technique involves preventing the deposition of the abrasion resistant metal oxide coatings on specific portions of the substrate (bottles, jars or the like). U.S. Patent No. 3,951,100, issued on April 20, 1976 to Sopko et al. is drawn to the chemical vapor deposition of coatings. This patent is related to U.S. Patent No. 3,888,649 discussed above, but is directed to the entire coating apparatus as opposed to the nozzle used to deliver the reactant. As described above, this vapor deposition technique uses carrier gas heaters. In U.S. Patent No. 3,958,530, issued on May 25, 1976 to Novice, an apparatus for coating an article is described. The apparatus hot end coats the bottom and sides of glass bottles in a single, continuous operation. A tin oxide coating is disclosed in U.S. Patent No. 3,959,565, issued on May 25, 1976 to Jordan et al. Glass is coated with SnOx, resulting in a resistivity of about 8-17 Ω per square, an infrared reflectivity of about 82% and a transmissivity of visible light of substantially 80%. A process for forming a metallic oxide coating is described in U.S. Patent No. 3,984,591, issued on October 5, 1976 to Plumat et al. This reference is cited as it discusses the temperatures necessary for coating glass using previously known methods. U.S. Patent No. 3,996,035, issued on December 7, 1976 to McHenry, teaches a method for coating and heat strengthening glass sheets. Discrete flat sheets of glass are heated, coated, reheated to tempering temperature and cooled to impart a partial temper to the coated sheets. A method and apparatus for coating a glass substrate are described in U.S. Patent No. 4,022,601, issued on May 10, 1977 to Sopko. A continuous glass ribbon is advanced from a float-forming chamber, past a first heat source and into a coating chamber. Another method and apparatus for coating glass is taught in U.S. Patent No. 4,042,363, issued on August 16, 1977 to Maeda et al. This patent is directed mainly to details of a hood that surrounds the spraying-coating zone. In U.S. Patent No. 4,056,650, issued on November 1, 1977 to Dates et al. a process for making aluminum-coated glass-ceramic cooking vessels is disclosed. The surface portion of the vessel to be coated is first pre-heated to a temperature of 120°-600° C. Finely divided molten aluminum is produced by combustion heating of the finely divided powdered aluminum and then sprayed onto the preheated surface portion. U.S. Patent No. 4,234,331, issued on November 18, 1980 to Gray et al. is directed to a coating method. This method involves applying metallic oxide coatings to a moving ribbon of glass as it exits a float chamber. A method and apparatus for forming tempered sheet glass with a pyrolytic film in a continuous process are disclosed in U.S. Patent No. 4,240,816, issued on December 23, 1980 to McMaster et al. The heated glass sheets are sprayed with a coating composition that reacts with the glass to form a metal oxide film on its surface. Chemical vapor deposition of a reflective film on a bottom surface of a float glass ribbon is shown in U.S. Patent No. 4,584,206, issued on April 22, 1986 to Sleighter. The coating apparatus is mounted just past the lift out rollers that lift the glass ribbon off the molten metal bath.

U.S. Patent No. 5,652,021, issued on July 29, 1997 to Hunt et al. discloses a method and apparatus for combustion chemical vapor deposition CCVD of films and coatings, and is hereby incorporated by reference. A reagent and a carrier medium are mixed together to form a reagent mixture. The mixture is then ignited to create a flame or the mixture is fed to a plasma torch. The energy of the flame or torch vaporizes the reagent mixture. U.S. Patent No. 5,858,465, issued on January 12, 1999 to Hunt et al. teaches a method and apparatus for the combustion chemical vapor deposition CCVD of phosphate films and coatings, and is also hereby incorporated by reference. CCVD is used to produce coatings of various phosphate compounds on substrates. U.S. Patent Nos. 5,863,604 and 6,013,318 issued on January 26, 1999 and January 11, 2000 respectively, both to Hunt et al. are drawn to methods and apparatus for combustion chemical vapor deposition of films and coatings, and these patents are also hereby incorporated by reference. Another concentrated heat coating method is described in European Patent Application No. EP 0 976 847 A2, published February 2, 2000. This reference describes a controlled atmosphere chemical vapor deposition CACVD that produces coatings of materials by providing a barrier zone of flowing gasses to keep atmospheric gasses from the deposition zone.

U.S. Patent No. 5,882,368, issued on March 16, 1999 to Falcony-Guajardo et al., discusses a method for coating glass substrates by ultrasonic nebulization of solutions. A fine mist is created, by nebulizing a solution using ultrasonic vibrations. Another method of producing a nebulized spray for use in a deposition method is described in U.S. Patent No. 5,997,956, issued on December 7, 1999 to Hunt et al. This patent describes a heated fluid conduit that controls the temperature and pressure of the coating reagent to produce the required atomization level. UK Patent GB 2 302 102, which issued to Hannotiau et al. on January 8, 1997, is directed to a glazing panel having solar screening properties. The reference notes when making multi-layer coatings using sprayed liquids, each deposition results in a significant cooling of the substrate. This cooling leads to a non-uniform coating, as well as requiring reheating of the substrate when the deposition of materials needing a higher deposition temperature is required. Pages 179-184 of the Journal of Non-Crystalline Solids 218 (1997) includes an article written by Jerome L. Buchanan and Clem McKown, that is drawn to an off-line sheet glass coating system. A tin-oxide conductive film is applied using a vapor delivery system, a coating nozzle, an oven and an emission control system. Pages 190-203 of the 5^{th} International Conference on CVD (1975) is directed to an article written by Blandenet, Lagarde and Spitz, and entitled, "Indium Oxide Deposition on Glass by Aerosol Pyrolysis." This process involves generating an aerosol by ultrasonic nebulization of an organic or inorganic solution.

The present invention consists in a method for concentrated heat deposition of a coating on a substrate (A), said method comprising the steps of:
(a) providing at least two coating heat sources (24) to deposit the coating on the substrate, the at least two coating heat sources being capable of heating a section of the substrate; and
(b) moving one of the substrate or the at least two coating heat sources relative to the other wherein:
   the section is first heated by one of the at least two coating heat sources, and after a first time period is heated by another of the at least two coating heat sources; and the first time period is long enough to allow thermal recovery of the section.

The present invention is directed to several methods for producing coatings, films or surface modifications on glass substrates using combustion chemical vapor deposition CCVD, atomizer sprayed solutions or other concentrated heat deposition methods. One type of atomizer that forms a controlled droplet size spray is known as the Nanomiser™. The Nanomiser produces this well controlled spray by releasing a solution that is heated above its STP boiling point from an orifice. This results in a heated spray contacting a portion of the substrate being coated. It is important to note that the term "glass" in this context is defined as those materials that crack, break or fail prior to plastic deformation of the material. It is often desirable to coat or otherwise modify a surface of these types of material to modify one or more characteristics of the surface of the material. For aesthetic purposes, one example of surface modification is the application of a tinted coating (which may be photo-reactive) to the glass surface. Safety coatings may be applied to increase the strength of the material and/or prevent shattering. In applications where the glass material is subjected to abrasion or caustic chemicals, an anti-corrosive film can be placed on the surface that is subjected to the adverse conditions. Electrically conductive surfaces are often useful on glass and glass-like materials. Hydrophobic and hydrophillic coatings can also impart desirable characteristics to exposed surfaces of the glass. One of the most common types of glass coatings is fluorine doped tin oxide. This coating is useful in the photovoltaic (PV) industry for forming transparent conductor oxides (TCO). The use of TCO in thin film solar cells is critical to the overall cost/performance of the final device. When TCO is used on plate glass for windows, they provide reduced solar heat gain for the dwelling during the summer, as well as reduced heat loss in the winter months. The present method provides a means by which high quality, uniform coatings of the above-mentioned types as well as a plethora of others, can be produced.

By using combustion chemical vapor deposition CCVD, the present method not only avoids the use of large quantities of dangerous vaporous products that must be collected, removed from carriers, recycled or carefully (and expensively) disposed of, but also provides a higher quality coating as described below. In CCVD, a reagent and a carrier solution are mixed together to form a reagent mixture. The reagent mixture is then ignited to create a flame, or alternatively, the reagent mixture may be fed to a plasma torch or other deposition means, method or apparatus that delivers concentrated heat toward the substrate as part of the deposition process. Regardless of the type of heat source used (flame, plasma torch, radiation, laser, heated atomized spray, etc.) any of these deposition methods can be broadly categorized as concentrated-heat deposition (CHD) techniques. The heat source vaporizes at least part of the reagent and the vapor phase of the reagent contacts the surface of the substrate to be coated. These methods for forming coatings generate thermal energy in close proximity to the substrate. This thermal energy can heat the substrate locally.

A challenge presented by using the CHD processes to coat glass and glass-like materials, is the possibility of shocking, stressing, cracking or breaking the substrate due to differential heating of the glass surface by the combustion source. This is further exacerbated in the case of materials having a low thermal conductivity. One method of decreasing this possibility is through preheating of the glass substrate by: providing a coating chamber about the substrate, and heating the air or gas within the coating chamber; radiation; other conduction or convection methods; using the heat generated by the deposition method; or any combination of these. The glass substrate does not necessarily need to be heated to the required coating temperature, but may be heated to some temperature under the temperature required for deposition to occur. For example, the substrate may be heated to within a predetermined temperature range of the required deposition temperature. When heated air or gas is used in the deposition process, the temperature of these gasses can be within 300, 100 or even 50° C of the substrate temperature, thereby providing the final small amount of thermal energy required for deposition. In this manner, while stresses to the glass are reduced, incidental deposition on portions of the substrate not in the combustion zone, and the imperfections related thereto, may be avoided. An alternate method to minimize damaging the substrate is rastering, or moving the combustion source relative to the glass substrate in a pattern that is offset by a small amount on each pass. By moving the combustion source past the glass substrate (or alternatively moving the substrate past a stationary flame or flames) no one portion of the substrate is allowed to reach a temperature that may damage the glass. This rastering is continued from one edge of the glass to the other, while carefully maintaining a constant speed to avoid variations in the thickness of the coating and excessive differential heating of the substrate.

In contradistinction, moving the flame or coating means at varying speeds is an option when thickness variations in the coating as a function of position on the substrate are desired. This may be preferred to form coatings wherein it is desired to have portions of the substrate with different characteristics than other portions of the substrate. One example of this is in the production of an optical diffraction grating. The varying speed is viable as long as the relative motion of the coating means and substrate are sufficient to avoid damage to the substrate. Of course, a pattern of differentially coated material can also be produced by the path of the relative movement of the coating means and substrate, even if a constant speed of this movement is maintained.

A further method of reducing differential heating while also increasing the rate of deposition, is the use of several flames or flame banks. A number of consecutive flames are positioned along the path of a conveyor (for example). As the substrate moves quickly past each flame, it is heated to a lessor extent by each individual flame or flame bank, thereby increasing the overall time the heat is applied to the substrate, but reducing thermal shock. Cooling means may also be employed between the flames or flame banks, to lower the maximum temperature to which the substrate is subjected. This cooling means may be in the form of air or water jets or radiant coolers.

Excessive differential heating may be avoided using a number of other techniques as well. By cutting concentrations of the combustible reagents relative to the other components of the precursor, the overall flame temperature can be lowered. Water or other non-combustible and non-depositing materials may also be directed into or near the flame or excess air can be entrained into or across the flame or the flame end. Adjusting the atomization level of the reagents and the particle sizes, will also change the flame temperature needed to form the coating material. These techniques can be especially useful for high-speed operations where the rastering, or partial heating of the substrate techniques, are impractical.

The combustion source itself, need not be aimed directly at the substrate, but can be at an angle to the substrate, such that the vapor is deposited without directly and excessively heating the portion of the substrate being coated. The actual distance between the flame and substrate can be increased. All of the above methods change the heat transfer to the substrate, and can be used separately or together in different combinations, in conjunction with the deposition method of the present invention.

Accordingly, it is a first object of the invention to apply thin film, multi-layer or relatively thick coatings to glass substrates without cooling the substrate and thereby degrading the quality of subsequent coatings.

It is another object of the invention to use CCVD to coat glass substrates to reduce thermal shock to the substrate during the coating process that can cause damage to the material of the substrate such as melting, degradation or change in the properties of the substrate.

It is a further object of the invention to coat glass substrates above the annealing, and tempering temperatures of the material of the substrate without requiring additional reheating steps.

It is a further object of the invention to heat and coat glass substrates and anneal or temper the coated substrate without requiring additional re-heating steps between the coating and annealing or tempering steps.

It is yet another object of the invention to provide a method of coating glass substrates wherein the substrate can be heated, coated and cut without subsequent processes, by maintaining the temperature of the substrate below the annealing or strain temperature of the substrate.

It is still another object of the invention to heat, coat and anneal glass substrates at varying temperatures of the substrate to increase the ability to cut the glass product produced thereby.

It is still yet a further object of the invention to coat glass substrates with coatings at glass temperatures below those required when using pyrolytic spray techniques, thereby reducing coating costs by eliminating the need for further reheating steps.

It is another object of the invention to provide a method of producing multi-layer coatings on glass substrates wherein subsequent coating steps are performed at the same or higher coating temperatures. This method thereby provides greater temperature control of the substrate, as well as allowing subsequent coatings of materials that require a higher substrate temperature than the materials of the underlying coatings.

These and other objects of the present invention will become readily apparent upon further review of the following specification and drawings.

### Brief Description of the Drawings

Figure 1 is a schematic of a roller conveyer fed, CCVD coating apparatus, used to carry out the method of the present invention.
Figure 2 is a diagrammatic plan view of a multi-flame bank, as used in the coating zone of the CCVD apparatus of figure 1.
Figure 3 is a diagrammatic plan view of a single flame, coating pattern used to simulate coating of the substrate by the multi-flame bank, CCVD apparatus of figure 2.
Figure 4 is a diagrammatic plan view of a coating pattern used to reduce thermal shock of the substrate by a single flame, CCVD apparatus.
Figure 5 a photomicrograph of a surface of a Ga doped ZnO coating on a soda-lime glass substrate.
Figure 6 is a photomicrograph of a cross-section of the Ga doped ZnO coating on a soda-lime glass substrate of figure 5.
Figure 7 is an X-ray diffraction pattern obtained from the Ga doped ZnO coating on a soda-lime glass substrate of figure 5.
Figure 8 is a photomicrograph of a cross-section of an ITO coating on a glass substrate.
Figure 9 is an X-ray diffraction pattern obtained from the ITO coating on a glass substrate of figure 8.
Figure 10 is a photomicrograph of a cross-section of a SiO₂ coating on a fluorine-tin-oxide coated glass substrate.
Figure 11 is a diagram of the surface compression and interior tension forces that exist in a piece of tempered glass.

### Detailed Description of the Preferred Embodiments

The present invention may be understood more readily by reference to the following detailed description of preferred embodiments of the invention and the Figures.

It is to be understood that the terminology used herein is for the purpose of describing particular embodiments only and is not intended to be limiting. It must be noted that, as used in the specification and the appended claims, the singular forms "a," "an" and "the" include plural referents unless the context clearly dictates otherwise.

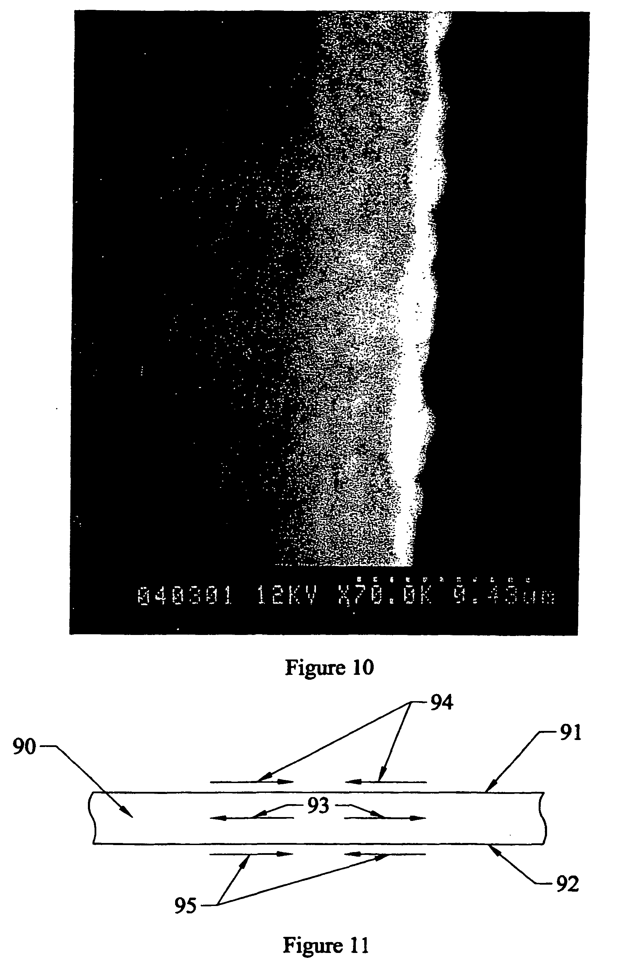

The numerous advantages of using the coating processes as taught by the present invention are best understood by first referring to figure 11. In figure 11, a glass substrate **90** is shown having a top surface **91** and a bottom surface **92.** As indicated by arrows **93,** the interior of the substrate is subjected to tension forces, while arrows **94** and **95** illustrate the counteracting compressive forces in the top and bottom surfaces, respectively. As is well known in the glass manufacturing art, if surface **91** is raised above a specific temperature relative to surface **92,** (hereafter referred to as ΔTₘₐₓ), the glass substrate will break, shatter or otherwise be damaged. This temperature difference, ΔTₘₐₓ is a function of the tempering of the glass and is also dependent on the overall temperature of the glass substrate **90**. To avoid exceeding this parameter (and thereby damaging the glass) during manufacture, glass articles are usually first cut and shaped prior to tempering the glass for the particular application. When coatings are applied to the glass surface before tempering, the coatings may actually be degraded by the tempering process. In the case of post tempering coating methods, care must be taken not to raise the substrate to a temperature that will change the temper. In addition, the coating process must also avoid raising the temperature of one surface more than ΔTₘₐₓ above the temperature of the opposite surface as well as other points on the same surface. This is a major advantage of the present invention over the coating methods of the prior art.

In the practice of using the CCVD, FAD, plasma torch or other CHD techniques to deposit coatings, a large amount of thermal energy is directed to a specific portion of a substrate resulting in localized temperature differentials. The directed thermal energy is an inherent part of these processes and the applicability of these techniques toward a broad range of substrates has therefore been limited prior to the disclosure of the instant invention. Certain substrates, because of their inability to be plastically deformed, low thermal conductivity, Young's modulus, material strength and combinations of these inherent properties, can be shocked by the localized application of such a heat source. Depending on the material in question, the material may be able to support differential temperatures of about 250° C. Some materials may be able to support differential temperatures in excess of 500° C while others may not survive at differential temperatures of 100°, 50°, 25° or even as low as 10° C. The amount of differential temperature a substrate will survive is often dependent on material quality and shape as well as the properties listed above. The actual maximum differential temperature that a substrate is capable of withstanding can be determined through testing and experimentation and this experimentation may be done in conjunction with limitations imposed by the selected deposition techniques, coating materials and desired coated article properties.

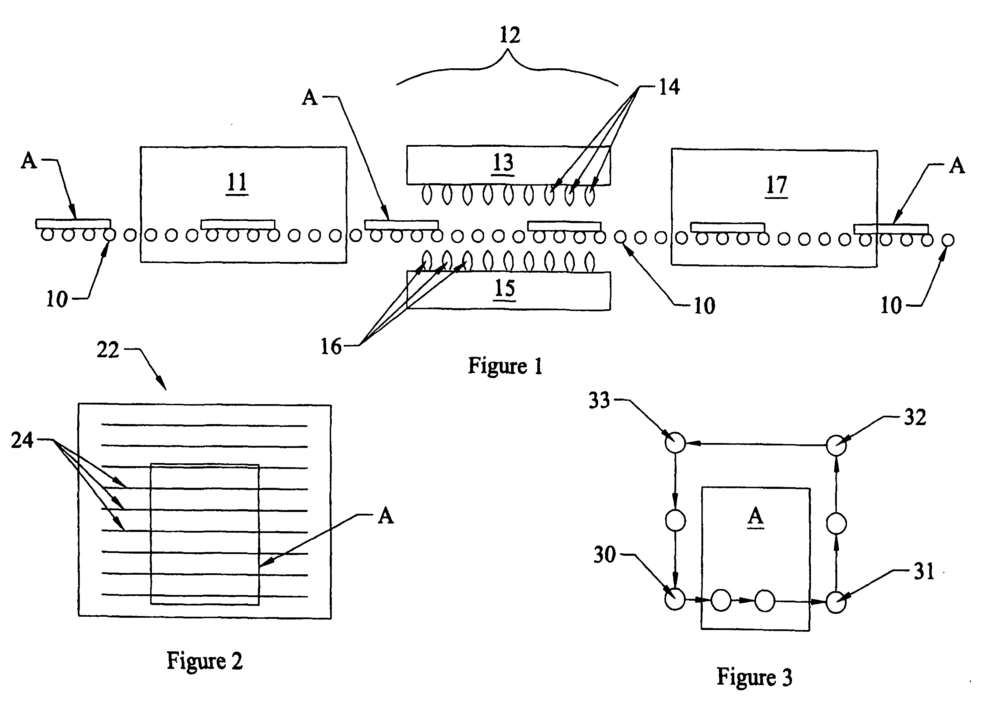

Referring now to figure 1, a roller conveyor having a plurality of rollers **10** for moving glass plates or other brittle substrates **A** through the various manufacturing stations is shown. A heating furnace or oven **11** is provided for applications where it is required to heat the substrate **A** prior to the coating step. Depending on the material deposited and the substrate, the substrate may not need to be heated, or heated to varying degrees. For example, the substrate may need to by heated to 50° C, 150° C, 400° C, 1000° C or even in excess of 2000° C. After leaving the furnace **11**, the substrates enter a coating zone **12** that may be in the form of a hood or chamber, or may be open to the atmosphere. Coating zone **12** includes a first, top flame bank **13** with a plurality of CCVD coating flames **14** directed generally downward therefrom. While the first, top flame bank **13** is provided for coating the top surface of the glass plates **A,** a second, bottom flame bank **15** with a second plurality of flames 16 directed upward therefrom, may optionally be provided. When it is desired to coat the bottom surface of plates **A,** as well as the top surface, flames **16** are CCVD equipped coating flames. Should it be desired to coat only the top surface of the glass plates **A,** the flames **16** may still be provided as simple heat sources for reducing the thermal stress associated with differential heating of the opposed glass surfaces. To this end, the flames of the top and bottom flame banks are generally oriented directly opposite one another. While there may be some offsets as required by other constraints, the general requirement is that ΔT is minimized. After exiting the coating zone **12,** the glass plates are directed to whatever post-processing station **17** or stations are desired.

The advantage of using CCVD or CHD techniques in the present invention are that no reheating is needed between the deposition of the coating and any optional post processing. This simplifies off-line, integrated coating and tempering and annealing operations. In fact, if properly done, the preheating energy requirement can be balanced by the energy imparted by the deposition technique, optimizing the overall process and reducing costs.

Another advantage of the instant invention is that the CCVD process can be performed at substrate temperatures substantially lower than those of traditional pyrolytic spray methods. This means that the coating can be applied below the annealing or strain temperature of the glass. Large sheets can therefore be coated and cut without costly annealing steps. This reduces the cost of the preheating means and may entirely eliminate post coating treatments to the substrate.

The rate of the flame passing the substrate or the substrate passing the flame (as is the case in figure 1) is dependent on the conditions necessary for the substrate to survive the coating process but also on the desired properties of the resultant article. Some of these conditions are: the desired thickness of the coating; the deposition rate of the process; and the above mentioned limitations in dealing with the thermal energy directed toward the substrate. The relative speed between the substrate and the flame may need to be less than 2.54 cm (1") minute, 25.4cm (10")/min, 127cm (50")/minute, 254cm (100")/min, 635cm (250")/minute, 2540cm (1000")/min, 50.8m (2000")/min, or even greater than 50.8m/minute.

The internal stresses in the substrate, that may break or shatter the substrate, are often created by the differential temperatures between the surfaces of the substrate. These temperature differentials may be alleviated by allowing the substrate time to recover between exposure to subsequent flame passes. The heat applied by the deposition process will diffuse into the bulk of the substrate, raising the overall temperature of the substrate. This recovery time will allow the surface of the substrate time to cool relative to its temperature immediately after exposure to the heat from the deposition process. In allowing this cooling, the stresses generated due to thermally derived expansion differences are minimized or reduced. The reduction of these stresses allows for multiple exposure to the flame or heat source without damaging the substrate. In alternate embodiments of the method an additional cooling jet could follow the path of the heat source as it traverses the substrate, thereby also minimizing the thermally derived stresses. The amount of time required between subsequent exposures to the coating means is dependent on the thermal conductivity of the substrate, other material properties and intrinsic and extrinsic properties of the deposition method and apparatus. The substrate may be able to survive exposure to subsequent flames when 10%, 25%, 50%, 75% or even 90% of the temperature increase from the previous flame is still present. These methods are very important so that the substrate is not fractured, shocked, warped, deformed or melted during the deposition process.

In some cases, when multi-layer coatings are desired, subsequent coatings would have better performance if the substrate were of higher temperature than the temperature of previous layers. In other methods of deposition, as in pyrolytic spray or CVD, the substrate is cooled by the deposition process, such that when multiple steps or passes are needed to get the required coating thickness, the portions of the coating last applied are of poorer performance than the previously applied portions of the coating. Both of these limitations are overcome by the instant invention of this patent. When CCVD or other CHD techniques are used in conjunction with the methods described herein, later portions of the same coating or later layers can be applied at higher substrate temperatures without the need of external heat sources or time consuming and expensive reheating means.

Referring to figure 2, a diagrammatic plan view of flame bank **22** of figure 1 is shown. Flames **24** are shown here in the form of lines, although each of these lines are actually made up of a series of individual point flames in a linear pattern. Glass plate **A** is shown being conveyed past flame bank **22,** the rollers **10** of the conveyor having been omitted for clarity. The multi-line flame configuration of flame bank **22** provides for several inherent advantages. One of the major advantages of this configuration is the reduced heating produced by each line of flames, in order to provide the same thickness of coating as a single line of flames. For example, if six flame lines **24** are used spaced 300 cm apart and the glass plate or ceramic substrate is conveyed at a rate of 254 cm/min, the same coating applied by a single flame line, would require a substrate speed of approximately 42 cm/min. Obviously, the single flame line configuration would result in a more rapid rate of heat transfer thereby producing a higher degree of thermal shock to the substrate. The actual spacing between the flame lines and number of flame lines would depend on the flame temperature, substrate material, coating material and other factors. Another useful advantage of the multi-line flame configuration is the ability to layer coatings of different materials. Each flame line **24** may be fed a different precursor solution, or subsequent flame lines could be fed similar precursors to produce relatively thicker and thinner coatings of different materials (i.e. six flame lines coating one material, followed by four flame lines coating a different material, and so on). By providing multi-line flame coating, the present method allows the material of the substrate to recover between flames, as well as reducing the temperature the substrate must be subjected to in order to form the coating. This allows much thicker coatings on substrate materials that are subject to thermal shocking, than have been realized with prior CCVD techniques.

The pattern of single flame deposition as shown diagrammatically in figure 3 is useful both for single flame coating as well as simulating the heating of the substrate produced when using the apparatus of figure 2. A single flame is initially held at position **30** relative to the substrate A. From position **30,** the flame is moved across the glass plate to position **31** at a constant rate of speed. After crossing the substrate, the flame is moved to position **32** to **33** and finally to initial position **30.** This process is repeated in order to reduce the heat transfer that results from a single flame pass, as well as to simulate the effect of several banks of flames on a linear portion of the substrate. To simulate the specific example described in the above paragraph, wherein six flames are used spaced 300 cm apart and the glass plate is conveyed at a rate of 254 cm/min, the following routine is used. The flame is moved from position **30** (where the flame first contacts the glass) to position **31** (where the flame first exits the glass) at 254 cm/min. From position **31** back to position **30,** a delay of 254 cm/min. divided by 300 cm (which equals approximately 0.85 min.) is used. For simplicity, the flame can move at a constant 254 cm/min., and the distance from position **31** to position **30** is calibrated to 300 cm. To simulate a six-flame bank, six passes of the flame are made. Clearly this same technique can be used to simulate a myriad of flame configurations, conveyor speeds, as well as coating and substrate materials. Furthermore, by moving the flame pattern incrementally upwardly (as viewed in figure 3) the entire surface of the substrate is eventually coated. This technique is useful to allow a long recovery time for particularly sensitive substrates. To increase deposition efficiency, the path of the flame from position 32 to position 33 may also pass over a portion of the substrate. Moving the flame over non-adjacent portions of the substrate prior to returning the flame to adjacent portions of the substrate, would further increase the recovery time realized by the substrate. Obviously a number of variations in the pattern the flame makes over the surface of the substrate may be envisioned without departing from the scope of the present invention.

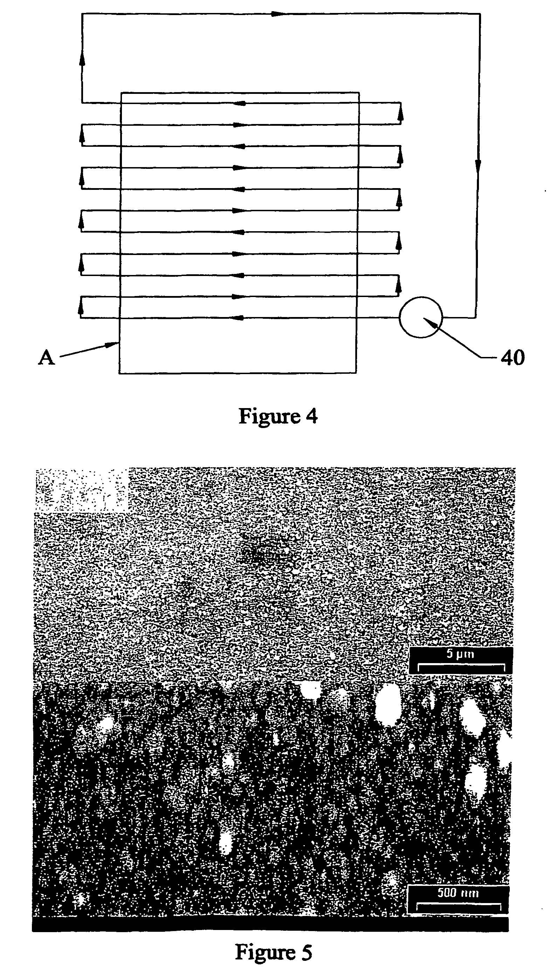

To further reduce localized differential heating of the substrate, the rastering pattern of single flame deposition as shown diagrammatically in figure 4 may be used. From position **40,** the flame is routed across the surface of substrate A, in a rastering fashion as shown by the arrows along path **41.** As the flame is moved at a relatively high rate of speed, no particular portion of the substrate is heated for too long. Due to the overall length of the path, each portion of the substrate is also given an extended period of time to recover. Another advantage of this pattern of flame deposition, is the gradual heating of the substrate from one end to the other, creating a slowly increasing, thermal conduction in a single direction. The distance between adjacent paths should be large enough to allow thermal recovery of the substrate, just as the distance between adjacent flame banks, as discussed with respect to figure 2 above. The overall rastering pattern of figure 4 can be moved upwardly (as viewed in figure 4) incrementally to insure a more uniform deposition by avoiding repeated depositions along the paths as shown. Conversely, should it be desired to form a coating having lines of greater and lesser coating thicknesses, the pattern can be repeated without incremental movement. To this end, the substrate A may be rotated by 90 and the coating operation repeated to form a gating pattern. This type of coating has many applications, such as a diffraction grating as used in the field of optics.

The above-described methods are useful for forming a number of different coatings on glass and glass-like substrates, these coatings including but not limited to: Ag; SiO₂; TiO₂; SnO₂; ITO; and numerous types of doped ZnO. The glass and glass-like substrates that the disclosed methods are particularly useful for placing coatings on include but are not limited to: vitreous, non-vitreous, mixtures of vitreous and non-vitreous phases, glass, float glass, ceramics, plastics, and transparent or opaque examples of these materials.

### Example 1

In this example, a Ga doped ZnO coating was formed on a 5.1x10.2cm (2" x 4") piece of soda-lime silica glass. A reagent solution containing the Ga and Zn precursors was dissolved in a combustible solvent. The resulting solution was delivered at a rate of 3.00ml/min., using oxygen as the carrier gas. The CCVD apparatus was a distance of 7.0 cm from the glass substrate, with a flame temperature of 1280 degrees C at the glass surface. The deposition pattern of figure 3 was used, with a relative velocity of 254cm (100")/min. for a total of 10 passes across the 5.1cm (2") direction of the glass. Approximately 9 seconds elapsed between passes. The substrate temperature was recorded at 392 degrees C., and the deposition was performed in the open atmosphere.

In figure 5 a photomicrograph of the surface of the Ga doped ZnO coating is shown. The upper half of the photomicrograph is magnified 4000X while the inset is magnified 40,000X. As can be seen, the coating is fine grained with the largest grains on the order of approximately 150nm, or 0.15 µm. This is indicative of a high quality coating.

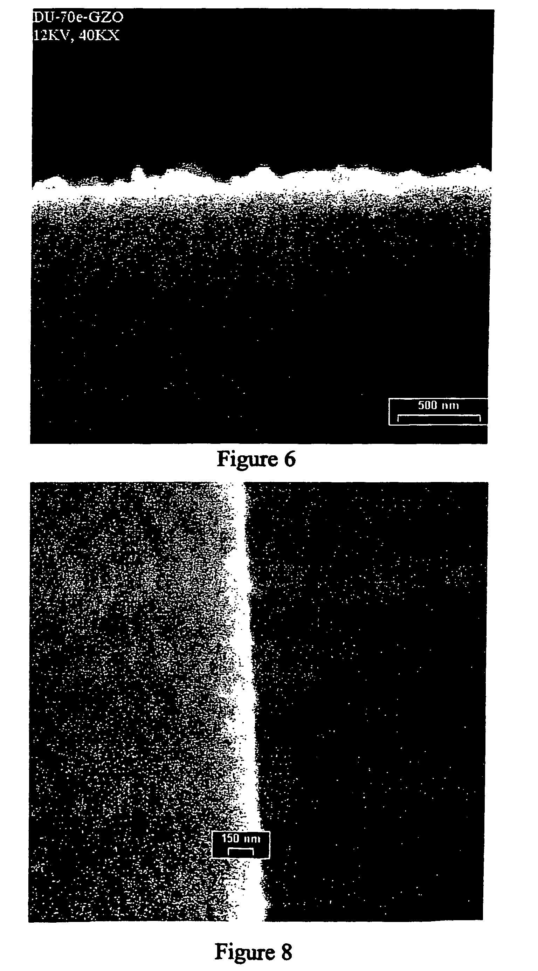

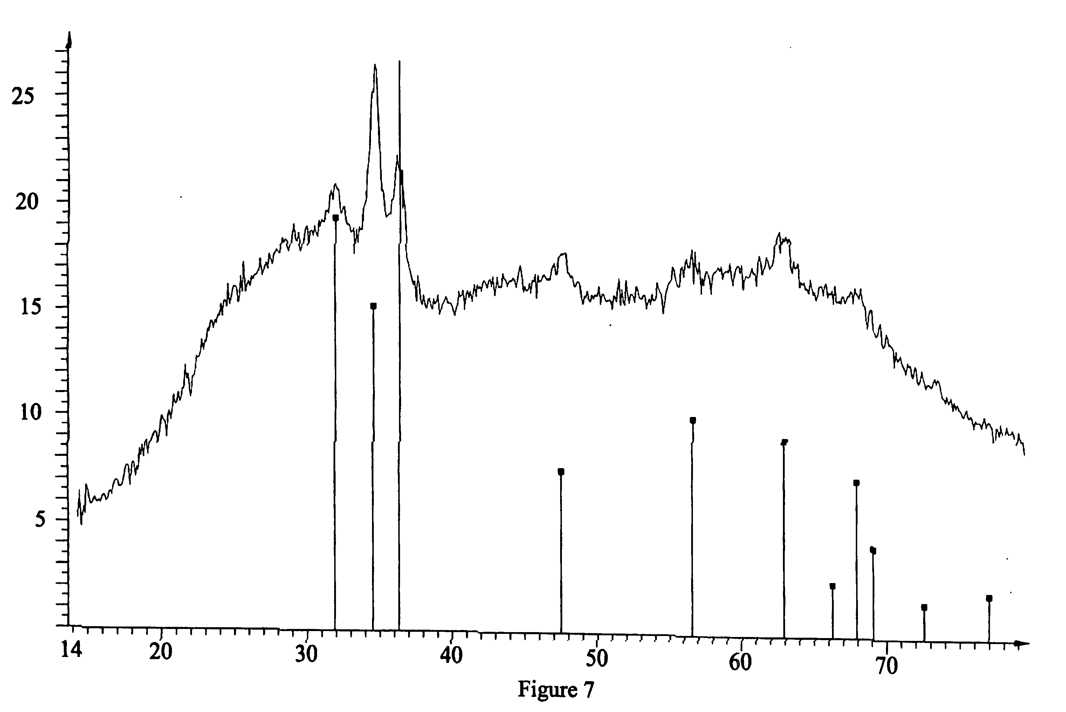

Referring now to figure 6, a photomicrograph of a cross-section of the Ga doped ZnO coating **60** and the soda-lime-silica glass substrate **61** is shown. Again, a 500nm scale is provided in the lower right hand corner of the photomicrograph. The thickness of the coating can be seen to be approximately 200nm or 0.20 µm. The maximum features of the surface of the coating are on the order of 0.15 µm. Once again it is apparent that a high quality coating has been deposited using the method of the present invention. An X-ray diffraction pattern obtained from the Ga doped ZnO coating on a soda-lime-silica glass substrate is shown in figure 7. The peaks confirm the formation of a crystalline ZnO thin film on the amorphous glass substrate.

### Example 2

In this example, an ITO (Indium-Tin-Oxide) coating was formed on an approximately 22.9 x 22.90 cm (9" x 9") piece of soda-lime glass. A reagent solution containing the indium and tin precursors was dissolved in a combustible solvent. The resulting solution was delivered at a rate of 3.00ml/min., using oxygen as the carrier gas. A flame temperature was maintained in the range of 950-1000 degrees C. The deposition pattern of figure 4 was used, with a relative velocity of 762cm (300")/min. for a total deposition time of 60 minutes. The substrate temperature was recorded at 451 degrees C., and the deposition was performed in the open atmosphere. The sample was annealed for 30 minutes after the coating process.

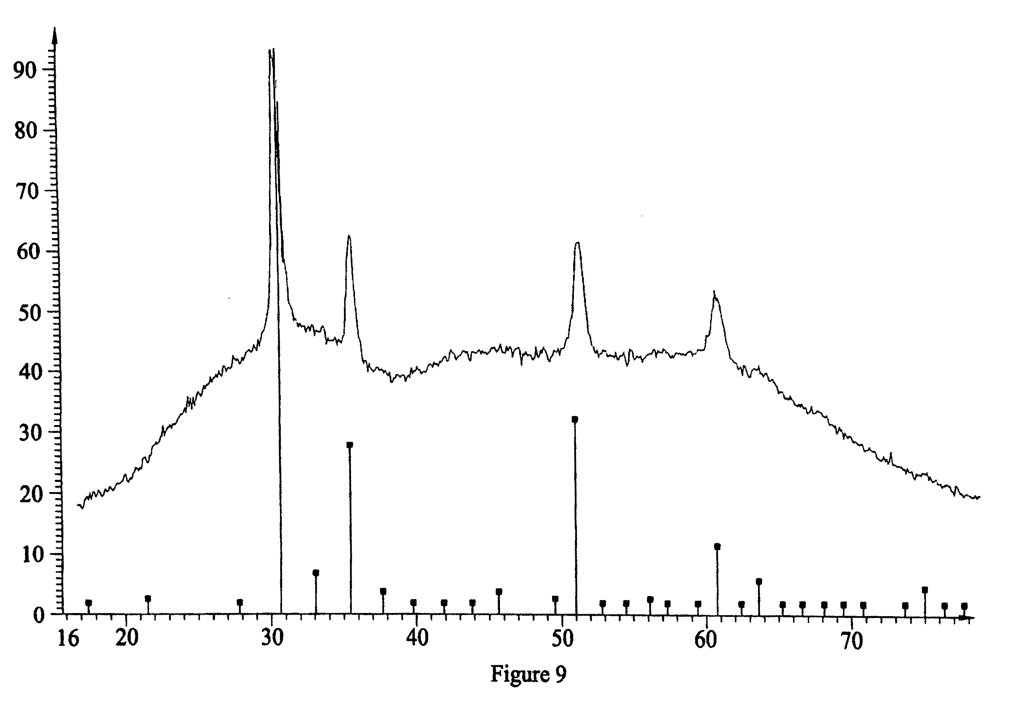

Turning to figure 8, a photomicrograph of a cross-section of the ITO coating on the glass substrate is shown. It can be seen that the overall thickness of the coating is approximately 175nm or 0.175 µm. Surface imperfections (grains) are on the order of 50nm. An X-ray diffraction pattern obtained from the ITO coating sample is shown in figure 9. The peak locations confirm the formation of a crystalline tin oxide thin film on the amorphous glass substrate.

### Example 3

In this example, a SiO₂ coating was formed on top of a Fluoride-Tin-Oxide (FTO) coated, 25.4 x 25.4 cm (10" x 10") piece of soda-lime glass. The FTO coating was deposited on the glass substrate on a float glass line. A reagent solution containing the Si precursor was dissolved in a combustible solvent. The resulting solution was delivered at a rate of 4.50ml/min., using compressed air as the carrier gas. The CCVD apparatus was a distance of 9.3 cm from the substrate, with a flame temperature of 1250 degrees C at the glass surface. The deposition pattern of figure 4 was used, with a relative velocity of 72.7m (500")/min. for a total deposition time of 24 minutes. The substrate temperature was recorded at 557 degrees C., and the deposition was performed in the open atmosphere.

The photomicrograph of the cross-section of the SiO₂ coating, the F-SnO₂ coating and the glass substrate is shown in figure 10. The eleven (11) dots at the lower right corner indicate a length of 430nm. As can be seen from the photomicrograph, the SiO₂ coating is approximately 100nm thick, and conforms to the 150nm F-SnO₂ coating without leaving any visible defects at the interface. Furthermore, the silica coating performed as a color suppression for the F- SnO₂ coating.

## Claims

1. A method for concentrated heat deposition of a coating on a substrate (A), said method comprising the steps of:
(a) providing at least two coating heat sources (24) to deposit the coating on the substrate, the at least two coating heat sources being capable of heating a section of the substrate; and
(b) moving one of the substrate or the at least two coating heat sources relative to the other wherein:
the section is first heated by one of the at least two coating heat sources, and after a first time period is heated by another of the at least two coating heat sources; and the first time period is long enough to allow thermal recovery of the section.

2. The method of Claim 1 wherein the substrate can be thermally shocked.

3. The method of Claim 1 or Claim 2 wherein the substrate is plastic.

4. The method of any preceding claim wherein at least one of said coating heat sources is at least one flame.

5. The method of Claim 4 wherein the relative movement of step (b) is at a velocity of 127 to 2540 cm (50 to 1000 inches) per minute.

6. The method of any preceding claim wherein the substrate is preheated prior to forming the coating.

7. The method of any preceding claim wherein the coating is an oxide, a metal or a mixture of oxide and metal.

8. The method of any preceding claim wherein the coating is chosen from nitrides, metals, borides, carbides and phosphides.

9. The method of any preceding claim wherein:
one of said at least two coating heat sources increases the temperature of the section by X degrees C.; and
the first time period is of a length sufficient to allow the temperature of the section to be reduced by between 10%-90% of X prior to heating by the other of the at least two coating heat sources.

10. A method according to any preceding claim wherein in step (b) the substrate is maintained at a temperature such that the coated substrate is tempered or annealed without the need for reheating.

11. The method of claim 10 wherein the maintaining of the temperature of the substrate preserves the original stress in the substrate such that the substrate can be coated, cooled and cut without a formal annealing process.

12. The method of claim 10 or claim 11 wherein the temperature of the substrate is maintained at a temperature that is equal to or below traditional pyrolytic spray temperatures.

## Patentansprüche

1. Verfahren zur konzentrierten Hitzeablagerung einer Beschichtung auf einem Substrat (A), wobei genanntes Verfahren die folgenden Schritte umfasst:
(a) Bereitstellen von mindestens zwei Beschichtungsheizquellen (24) zur Ablagerung der Beschichtung auf dem Substrat, wobei die mindestens zwei Beschichtungsheizquellen zum Erhitzen eines Abschnitts des Substrats fähig sind; und
(b) Bewegen eines der Substrate oder der mindestens zwei Beschichtungsheizquellen relativ zur anderen, worin:
der Abschnitt zuerst mittels einer der mindestens zwei Beschichtungsheizquellen erhitzt wird, und nach einer ersten Zeitspanne mittels einer anderen der mindestens zwei Beschichtungsheizquellen erhitzt wird; und die erste Zeitspanne lang genug ist, um eine thermische Erholung des Abschnitts zu erlauben.

2. Verfahren nach Anspruch 1, worin das Substrat thermisch geschockt werden kann.

3. Verfahren nach Anspruch 1 oder 2, worin das Substrat Kunststoff ist.

4. Verfahren nach einem der vorangehenden Ansprüche, worin mindestens eine der genannten Beschichtungsheizquellen mindestens eine Flamme darstellt.

5. Verfahren nach Anspruch 4, worin die relative Bewegung von Schritt (b) bei einer Geschwindigkeit von 127 bis 2540 cm (50 bis 1000 Inches) pro Minute abläuft.

6. Verfahren nach einem der vorangehenden Ansprüche, worin das Substrat vor dem Bilden der Beschichtung vorerhitzt wird.

7. Verfahren nach einem der vorangehenden Ansprüche, worin die Beschichtung ein Oxid, ein Metall oder ein Gemisch aus einem Oxid und Metall darstellt.

8. Verfahren nach einem der vorangehenden Ansprüche, worin die Beschichtung aus Nitriden, Metallen, Boriden, Carbiden und Phosphiden ausgewählt ist.

9. Verfahren nach einem der vorangehenden Ansprüche, worin:
Eine der genannten mindestens zwei Beschichtungsheizquellen die Temperatur des Abschnitts um X °C erhöht; und
die erste Zeitspanne von einer Länge ist, die ausreicht, um der Temperatur des Abschnitts zu erlauben, zwischen 10 % und 90 % von X vor dem Erhitzen mittels der anderen der mindestens zwei Beschichtungsheizquellen reduziert zu werden.

10. Verfahren nach einem der vorangehenden Ansprüche, worin in Schritt (b) das Substrat bei einer Temperatur dergestalt aufrechterhalten wird, dass das beschichtete Substrat ohne Notwendigkeit des erneuten Erhitzens getempert oder entspannt wird.

11. Verfahren nach Anspruch 10, worin das Aufrechterhalten der Temperatur des Substrats die ursprüngliche Spannung im Substrat dergestalt erhält, dass das Substrat, ohne formales Entspannungsverfahren, beschichtet, gekühlt und geschnitten werden kann.

12. Verfahren nach Anspruch 10 oder 11, worin die Temperatur des Substrats bei einer Temperatur, die gleich oder unter üblichen pyrolitischen Sprühtemperaturen liegt, aufrechterhalten wird.

## Revendications

1. Procédé de déposition à la chaleur concentrée d'un revêtement sur un substrat (A), ledit procédé comprenant les étapes consistant à :
(a) disposer au moins deux sources de chaleur de revêtement (24) pour déposer le revêtement sur le substrat, les au moins deux sources de chaleur de revêtement étant capables de chauffer une section du substrat ; et
(b) déplacer l'un parmi le substrat et les au moins deux sources de chaleur de revêtement vis-à-vis de l'autre, où :
la section est d'abord chauffée par l'une des au moins deux sources de chaleur de revêtement, et après une première période de temps, est chauffée par une autre des au moins deux sources de chaleur de revêtement ; et la première période de temps est suffisamment longue pour permettre une récupération thermique de la section.

2. Procédé selon la revendication 1, dans lequel le substrat peut être soumis à un choc thermique.

3. Procédé selon la revendication 1 ou la revendication 2, dans lequel le substrat est en matière plastique.

4. Procédé selon l'une quelconque des revendications précédentes, dans lequel au moins l'une desdites sources de chaleur de revêtement est au moins une flamme.

5. Procédé selon la revendication 4, dans lequel le mouvement relatif de l'étape (b) est à une vitesse de 127 à 2540 cm (50 à 1000 pouces) par minute.

6. Procédé selon l'une quelconque des revendications précédentes, dans lequel le substrat est préchauffé avant formation du revêtement.

7. Procédé selon l'une quelconque des revendications précédentes, dans lequel le revêtement est un oxyde, un métal ou un mélange d'oxyde et de métal.

8. Procédé selon l'une quelconque des revendications précédentes, dans lequel le revêtement est choisi parmi les nitrures, les métaux, les borures, les carbures et les phosphures.

9. Procédé selon l'une quelconque des revendications précédentes, dans lequel :
l'une desdites au moins deux sources de chaleur de revêtement augmente la température de la section de X degrés C ; et
la première période de temps a une longueur suffisante pour permettre à la température de la section d'être réduite de 10-90 % de X avant chauffage par l'autre des au moins deux sources de chaleur de revêtement.

10. Procédé selon l'une quelconque des revendications précédentes, dans lequel, dans l'étape (b), le substrat est maintenu à une température telle que le substrat revêtu est trempé ou recuit sans qu'un re-chauffage soit nécessaire.

11. Procédé selon la revendication 10, dans lequel le maintien de la température du substrat préserve la contrainte originale dans le substrat de façon que le substrat puisse être revêtu, refroidi et découpé sans procédé de recuit formel.

12. Procédé selon la revendication 10 ou la revendication 11, dans lequel la température du substrat est maintenu à une température égale ou inférieure aux températures de pulvérisation pyrolytiques traditionnelles.
